# EUROPEAN PATENT SPECIFICATION

(11) **EP 1 485 944 B1**
(45) Date of publication and mention of the grant of the patent: **13.06.2012**
(21) Application number: 03723766.6
(22) Date of filing: 17.03.2003
(51) Int. Cl.: G03F 7/00, H01L 21/304, H01L 21/268, B82Y 10/00

(54) **RADIATION ASSISTED DIRECT IMPRINT LITHOGRAPHY**
STRAHLUNGSUNTERSTÜTZTE DIREKTDRUCKLITHOGRAPHIE
LITHOGRAPHIE A IMPRESSION DIRECTE ASSISTEE PAR IRRADIATION

(30) Priority: 15.03.2002 US 364653 P; 07.05.2002 US 140140
(43) Date of publication of application: 15.12.2004
(73) Proprietor: Princeton University, P.O. Box 36, Princeton, NJ 08540 (US)
(72) Inventor: CHOU, Stephen, Y., Princeton, NJ 08540 (US)
(74) Representative: Beresford, Keith Denis Lewis
(86) International application number: PCT/US2003/008293
(87) International publication number: WO 2003/079416

(56) References cited:
- EP-A- 1 072 954
- WO-A-99/64642
- WO-A-02/077716
- US-A- 5 259 926
- US-A- 5 772 905
- US-B1- 6 190 929
- US-B1- 6 309 580

## Description

This invention relates to imprint lithography and, in particular, to radiation assisted direct imprint lithography (LADI) wherein radiation permits direct imprinting of a mold on a substrate surface. The process is particularly useful in directly imprinting nanoscale features on solid substrates.

### BACKGROUND OF THE INVENTION

Methods of patterning small features onto substrates arc of great importance in the fabrication of many electronic, magnetic, mechanical, and optical devices as well as devices for biological and chemical analysis. Such methods are used, for example, to define the features and configurations of microcircuits and the structure and operating features of planar optical waveguides and associated optical devices.

Optical lithography is the conventional method of patterning such features. A thin layer of photoresist is applied to the substrate surface and selected portions of the resist are exposed to a pattern of light. The resist is then developed to reveal a desired pattern of exposed substrate for further processing such as etching. A difficulty with this process is that resolution is limited by the wavelength of the light, scattering in the resist and substrate, and the thickness and properties of the resist. As a consequence optical lithography becomes increasingly difficult as desired feature size becomes smaller. Moreover applying, developing and removing resists are relatively slow steps, limiting the speed of throughput.

A more recent approach to patterning small features is nanoimprint lithography wherein a nanofeatured molding surface is imprinted into a resist or resist-like material (polymer) and the imprinted pattern is removed to selectively expose the substrate surface. This process eliminates the limitations on resolution caused by the wavelength of light, but nonetheless has limitations imposed by the use and processing of resists or polymers. Further details concerning nanoimprint lithography are set forth in applicant's United States Patent No. 5,772,905 issued June 30, 1998 and entitled "Nanoimprint Lithography" and U.S. Patent 6,482,742 issued November 19, 2002 and entitled "Fluid Pressure Imprint Lithography".

The electronics and optical communications industries, as well as companies entering new fields of nanotechnology, continue to seek new methods for the production of microcircuits, optical devices and new nanoscale structures. In particular they seek faster processes for patterning substrates with higher resolution patterns.

WO 99/64642A describes a method of fabricating nanostructures in which a mould is pressed into a heated metal coated on a substrate.

EP 1072954A describes a lithographic process in which an energy-curable material is hardened by exposure to radiation using a mould which is transparent to the radiation.

US 5,772,905 describes a lithographic process in which a mould is pressed into a thin film carried on a substrate.

Aspects of the present invention are set out in the appended independent claims.

### SUMMARY OF THE INVENTION

In accordance with the invention, features can be directly imprinted into the surface of a solid substrate. Specifically, a substrate is directly imprinted with a desired pattern by the steps of providing a mold having a molding surface to imprint the pattern, disposing the molding surface adjacent or against the substrate surface to be imprinted, and irradiating the substrate surface with radiation to soften or liquefy the surface. The molding surface is pressed into the softened or liquefied surface to directly imprint the substrate. The invention is defined in the claims. The substrate can be any one of a wide variety of solid materials such as semiconductors, metals, or polymers. In a preferred embodiment the substrate is silicon, the laser is a UV laser, and the mold is transparent to the UV radiation to permit irradiation of the silicon workpiece through the transparent mold. Using this method, applicants have directly imprinted into silicon large area patterns with sub-10 nanometer resolution in sub-250 nanosecond processing time. The method can also be used with a flat molding surface to planarize the substrate.

### BRIEF DESCRIPTION OF THE DRAWINGS

The advantages, nature and various additional features of the invention will appear more fully upon consideration of the illustrative embodiments shown in the accompanying drawings described in detail below. In the drawings:
Fig. 1 is a schematic flow diagram showing the steps involved in laser assisted direct imprint lithography;
Fig. 2A - 2E show the mold and substrate at various stages of the Fig. 1 process;
Fig. 3 is a graph plotting the reflectivity of a HeNe laser beam from the silicon surface as a function of the time when the silicon surface is irradiated;
Fig. 4 illustrates a scanning electron micrograph of an imprinted silicon grating;
Fig. 5(a) is a scanning electron micrograph of a cross-sectional view of a quartz mold;
Fig. 5(b) is a scanning electron micrograph of a cross-sectional view of a silicon substrate imprinted by the method of Fig. 1;
Fig. 6 is an atomic force micrograph of an isolated silicon square pattern produced by the method of Fig. 1;
Fig. 7 is a scanning electron micrograph of a quartz mold following two applications of the method of Fig. 1.

It is to be understood that these drawings are for the purposes of illustrating the concepts of the invention and, except for the graph, are not to scale.

### DETAILED DESCRIPTION

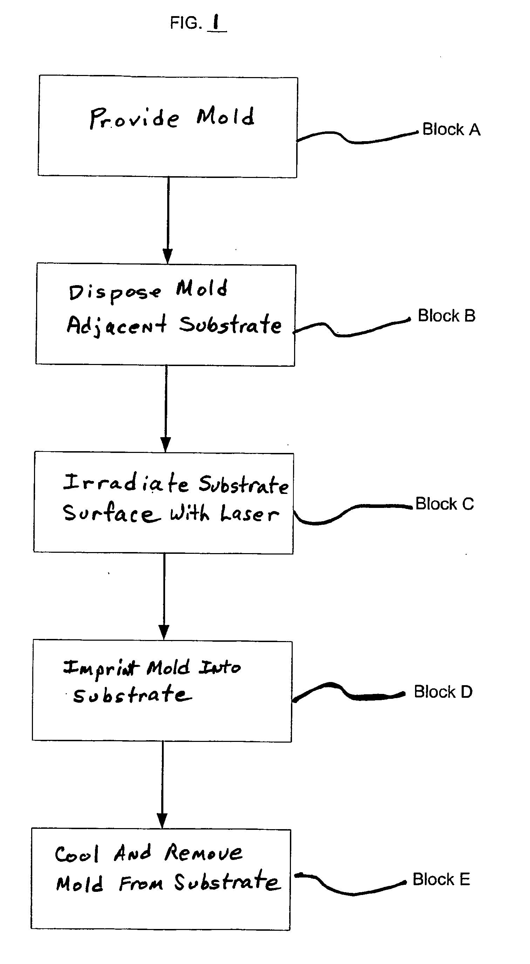

Referring to the drawings, Fig. 1 is a schematic block diagram showing the steps involved in laser assisted direct imprinting a desired pattern into the surface of a substrate without the interposition of a resist or polymer material. The first step shown in Block A is to provide a mold having a molding surface to imprint the desired pattern.

The next step, Block B, is to dispose the mold with the molding surface adjacent the substrate surface to be imprinted. The molding surface can be pressed against the substrate surface.

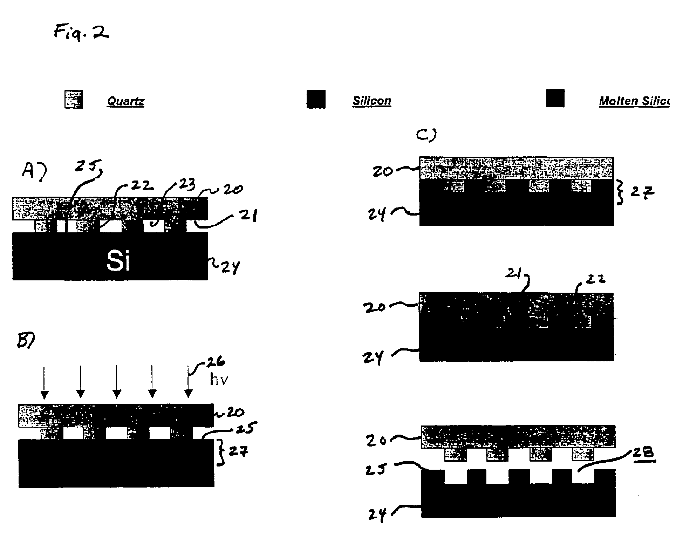

Fig. 2A shows the mold 20 having a molding surface 21 comprising one or more projecting features 22 and one or more recessed regions 23. The mold 20 is disposed near a substrate 24 having a surface 25 to be imprinted. The molding surface 21 is adjacent the surface 25.

The substrate 24 can be any material that will soften or liquefy in response to laser radiation and return to its original state when the laser exposure is terminated. The mold 20 is advantageously composed of a material transparent to the laser radiation so that the substrate surface 25 can be irradiated through the mold.

The molding surface 21 can have microscale or nanoscale features. Advantageously the surface comprises a nanofeatured pattern having at least one feature with a minimum dimension of less than 200 nanometers, for example the lateral dimension of a projecting feature 22 can be less than 200 nanometers. Also advantageously, the molding surface presents a mold depth of less than 250 nanometers, i.e. the distance between the outer portion of a projecting feature 22 and the inner portion of an adjacent recessed region 23 can be less than 250 nanometers and preferably in the range 5 - 250 nanometers. For planarizing the substrate surface, however, the molding surface is advantageously flat.

In a preferred embodiment, the substrate is silicon, the laser is a UV laser, and the mold is a fused quartz. A typical mold can be composed of 1 millimeter thick fused quartz having patterns with features ranging in size from 10 nanometers or less to tens of microns. Other advantageous substrates include other semiconductors, metals, semimetals, polymers and ceramics.

The substrate surface layer to be molded can be a multilayered structure of thin films of material selected among semiconductors, metals, semimetals, polymers and insulators. The surface layer can also be composed of plural surface regions, different surface regions formed of different materials.

The third step (Block C) is to irradiate the substrate surface to be molded with radiation to soften or liquefy the surface.

Fig. 2B illustrates a preferred arrangement for irradiation wherein radiation 26 from a source (not shown) passes through the mold 20 to irradiate surface 25 of the substrate. The radiation, which can be laser radiation, forms a softened or liquefied surface region 27 on the substrate 24.

Useful radiation sources include lasers (ultraviolet, infrared and visible light) and lamps (narrow band and broad spectrum). Laser radiation is advantageously in the range 1 nanometer to 100 micrometers. Lamp radiation is advantageously in the range 1 nanometer to 50 micrometers. The irradiation is pulsed, with a time duration in the range 1 nanosecond to 10 seconds.

The next step shown in Block D of Fig. 1 is to imprint the substrate by pressing the molding surface into the softened or liquefied surface region.

This pressing can be accomplished by a mechanical press as described in the aforementioned U.S. Patent No. 5,772,905, by fluid pressure as described in U.S. Patent No. 6,482,742 or by any other method of applying force. The pressure can be applied beginning prior to the irradiation. One advantageous approach is to press the mold against the substrate and, during the pressing, irradiate the substrate surface with a plurality of pulses.

Fig. 2C shows the substrate with the molding surface 21 imprinting the surface region 27.

To complete the imprinting process, the irradiation is terminated as by switching off the source, the surface region is permitted to cool slightly, and the molding surface is removed from the substrate.

Fig. 2D illustrates the mold 20 removed from the substrate 24, leaving the imprinted mold pattern 28 on the substrate surface 25.

The invention may now be more clearly understood by consideration of the following specific examples:

### Example

A series of experiments were conducted using molds having the following three patterns: (1) grating of 140 linewidth, 110 nm depth, and 300 nm period; (2) lines 10 nm wide and 15 nm deep, which were created due to the trenching effect in reactive ion etching during mold fabrication; and (3) rectangles of length and width in tens of microns and a depth of 110 nm. All three patterns were imprinted directly in silicon in the same LADI process.

First, a quartz mold, as described above, was brought into contact with a silicon substrate. Two large press plates were used to supply the force which pressed the mold against the substrate. The silicon wafer was placed on the lower plate with the mold on top of the wafer. The top plate, also made of fused quartz and hence transparent to the laser beam, was placed on top of the mold. The two plates were pressed together by increasing the pressure provided by screws between the two large plates. The preferred level of pressure applied to bring the mold and the substrate into contact was approximately 1.7 x 10⁶ Pa or about 17 atmospheres pressure. This pressure level produces an imprint depth of ~110 nm in an imprint time of ~250 ns. It is preferable to have the pressure applied before introduction of the laser pulse.

Next, a laser pulse was applied to the mold-substrate assembly. In one experiment, a single XeCl excimer laser pulse having a wavelength of 308 nm, a pulse duration of 20 ns at FWHM, and a fluence of 1.6 J/cm², was applied to the assembly. The laser passed through the quartz mold with very little energy absorbed by the mold. The transmittance of the mold for the laser radiation was measured and found it to be ~93%. The difference in refractive index at the two mold-air interfaces caused a total radiation reflection of ~7% indicating the mold itself does not absorb the laser radiation.

The single laser pulse irradiates the silicon surface, inducing the melting and liquefying the silicon for approximately 250 ns. Advantageously, the melting of the substrate surface can be monitored *in situ* during the LADI process by measuring the time-resolved reflectivity of a laser beam from the substrate surface. Reflectivity is the ratio of the energy of a wave reflected from a surface to the energy possessed by the wave striking the surface. When silicon melts, it changes from a semiconductor to a metal and the silicon's surface reflectivity to visible light increases by a factor of two.

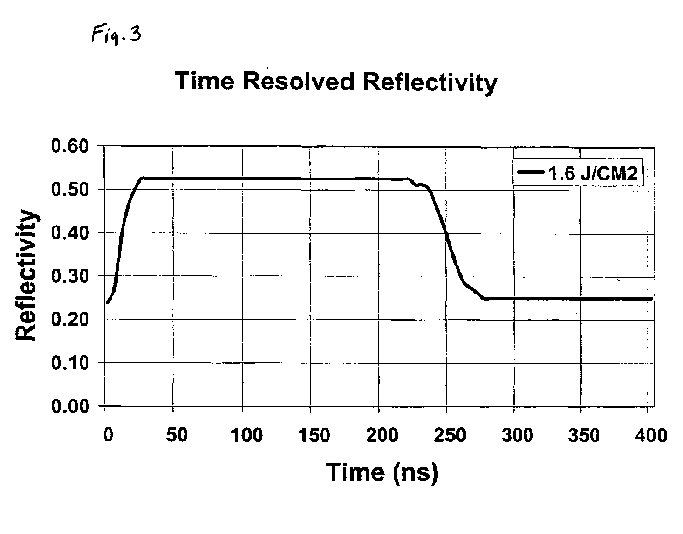

In one experiment, a HeNe laser beam having a wavelength of 633 nm was used to measure the reflectivity. Fig. 3 shows the measured reflectivity of a silicon surface exposed to a single 20 ns XeCl excimer laser pulse at a fluence of 1.6 J/cm². As shown by the graph, the reflectivity of solid silicon is approximately .25. Under the radiation, the reflectivity of the silicon surface increased rapidly in the first 25 ns, saturated for 200 ns at a reflectivity of approximately .50, and returned to the original solid silicon reflectivity in 50 ns.

While the substrate was in a liquid state the mold was embossed into the liquid substrate layer. The low viscosity of molten silicon enables the molten silicon to flow rapidly into all crevasses, filling them completely and conforming to the mold. The melting period of the silicon is approximately equivalent to 20 ns, the duration of the laser pulse. In Fig. 3, the 25 ns raising edge of the reflectivity, which is slightly longer than the pulse duration, might be related to the RC time constant of the oscilloscope (100 MHz), which is 10 ns.

The mold and the substrate were then separated, leaving a negative profile of the mold pattern imprinted on the substrate surface. Typically, the transformation from liquid to solid causes the substrate volume to expand about 3% in each direction which may aid the conformation of the substrate to the mold features for achieving sub-10 nm resolution. It is desirable to separate the substrate and the mold easily, so not to damage either the imprinted features in the substrate or the features of the mold. Experimentation shows the separation is aided by the fact that the quartz mold has a lower coefficient of thermal expansion (5 x 10⁻⁷ K⁻¹) than silicon (2.5 x 10⁻⁶ K⁻¹).

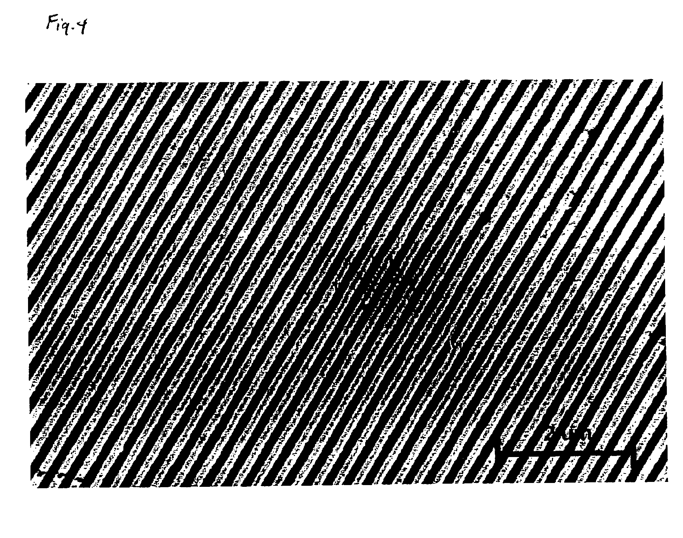

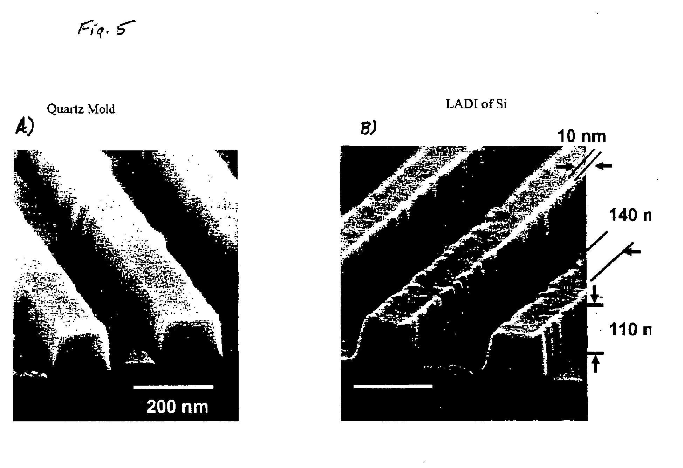

Fig. 5(A) is a scanning electron micrograph showing a cross-sectional view of a quartz mold. Fig. 4 and Fig. 5 (B) are scanning electron micrographs showing a top and cross-sectional view, respectively, of the features imprinted in a silicon substrate as a result of LADI. The imprinted grating resulting from LADI has a 140 nm linewidth, 110 nm depth and 300 nm period, which is consistent with the features of the mold One of the most interesting features in Fig. 5(B) is the ridge formed along the top corners on the imprinted grating lines. These ridges are approximately 10 nm wide and 15 nm high. A comparison to the scanning electron micrograph of the mold in Fig. 5(A) clearly indicates that these ridges come from the notches formed in the mold caused by the trenching effect of the reactive ion etching of the mold. The complete transfer of these 10 nm ridges in a LADI process suggests that the resolution of LADI is better than 10 nm.

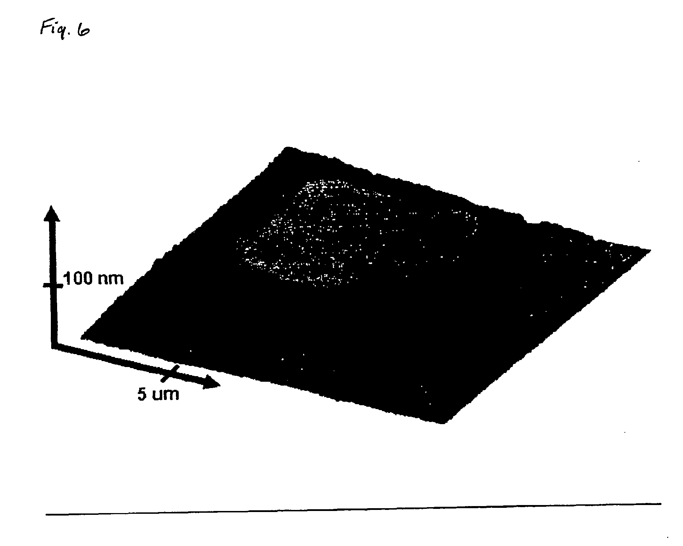

LADI also results in the imprinting of large, isolated patterns. Typically, LADI can pattern mesas and trenches of over tens of microns in size. Fig. 6 shows a silicon substrate imprinted by LADI with an isolated square mesa having a width of 8 µm and height of 110 nm. The successful imprinting of such large patterns indicates that the molten silicon can easily flow over tens of microns within nanoseconds.

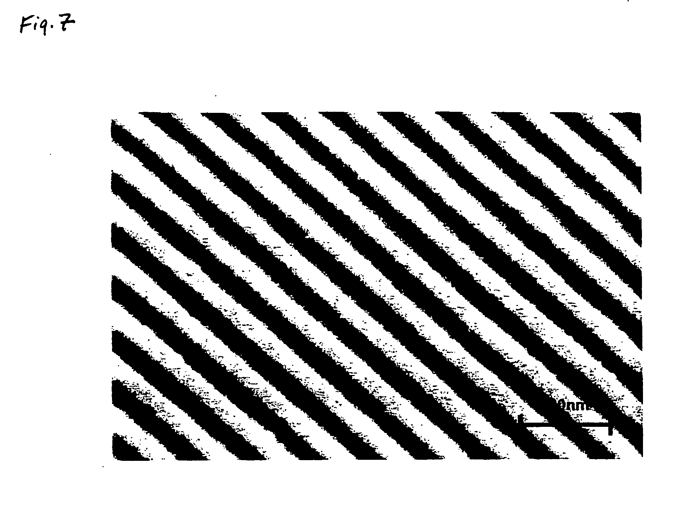

Fig. 7 shows a scanning electron micrograph of a quartz mold following two applications of LADI. Notably, the mold shows no visible damage due to the multiple LADI applications.

While UV laser radiation sources are advantageous, depending on the substrate other sources can be used. Infrared lasers can be used to soften or liquefy many metals and even pulsed heat lamps can be used to melt or soften many polymers.

If the surface to be imprinted comprises a plurality of layers, a combination of layers can be imprinted at the same time. The radiation can be chosen to melt a layer of material that can melt, through heat transfer, adjacent layers.

The pulse duration of the radiation can be selected upon the imprint process and the pulse is short enough so that only the surface layer of the substrate being heated and the rest of the substrate as well as the mold will not be heated significantly.

It is also possible that there are pre-fabricated patterns on the substrate and there is alignment between the pattern on the substrate and the pattern on the mold.

The equipment for laser assisted direct imprint can have alignment capabilities comprising stages for the substrates and mold respectively and also the mechanical stage to create the relative movement between the substrates and the mold in x, y, z, zeta, tilt and yank (all possible degrees of freedom). The sensors can monitor the relative movement between the substrates and the mold as well as monitoring the imprint heating pressure and information of the imprint controller would have monitoring feedback and control system.

It is contemplated that the above-described method can be used in a series of steps to form complex structures. A substrate can have an existing pattern, and the pattern on the mold can be aligned in relation to the existing substrate pattern before imprinting. A substrate can be patterned as described, a layer can be added and planarized if necessary, and the added layer can be patterned in the same manner but in a different configuration. Multiple successive layers can be imprinted with aligned patterns to form complex devices in the same manner that integrated circuits are formed. The substrate can comprise a thin layer of radiation absorbing material on a substrate transparent to the radiation This method can be used with a polymer coated substrate to imprint a pattern into resists and then use the patterned resist to pattern the substrates as described in U.S. Patent No. 5,772,905.

Moreover the process can be used to make many devices on the same substrate using step and repeat imprinting and automatic alignment techniques well known in the art.

The imprinted substrates can have recessed regions that will hold patterns of material added after the imprinting. The added material can be magnetic or conductive to form tiny electromagnetic components. The recessed regions can even act as microscale or nanoscale molds for the fabrication of tiny components.

Microscale or nanoscale grooves can be imprinted into the substrate to select, orient and direct macromolecules, and imprinted peaks or recesses can be provided for attachment of indicators that will selectively attach to target molecules.

It is to be understood that the above described embodiments are illustrative of only a few of the many embodiments which can represent applications of the invention. Numerous and varied other arrangements can be made by those skilled in the art without departing from scope of the invention.

## Claims

1. A method of directly imprinting a mold pattern on the surface (25) of a substrate (24) comprising the steps of:
providing (A) a mold (20) having a molding surface (21) to imprint the pattern;
disposing (B) the mold near the substrate with the molding surface adjacent the substrate surface to be imprinted;
irradiating (C) the substrate surface with radiation to soften or liquefy the substrate surface;
pressing (D) the molding surface into the softened or liquefied substrate surface; and
removing (E) the molding surface from the substrate to leave the substrate with the imprinted pattern of the molding surface;
**characterised in that** the irradiating step irradiates the surface with pulsed radiation which is pulsed with a time duration in the range 1 nanosecond to 10 seconds such that only a surface layer of the substrate is heated and the rest of the substrate is not heated significantly.

2. The method of claim 1 wherein the radiation is laser radiation.

3. The method of claim 2 wherein the laser radiation is of wavelength in range 1 nanometer to 100 micrometers.

4. The method of claim 1 wherein the radiation is lamp radiation.

5. The method of claim 4 wherein the lamp radiation is predominantly in the range 1 nanometer to 50 micrometers.

6. The method of claim 1 wherein the irradiation is pulsed repeatedly while the mold is pressed against the substrate.

7. The method of claim 1 wherein the mold comprises material transparent to the radiation.

8. The method of claim 1 wherein the mold comprises fused quartz.

9. The method of claim 1 wherein the molding surface comprises a pattern of projecting an recessed features having at least one feature with a minimum dimension of less than 200 nanometers.

10. The method of claim 1 wherein the molding surface comprises a pattern of projecting and recessed features having a mold depth of less than 250 nanometers from the outer portion of a projecting feature to the inner portion of an adjacent recessed region.

11. The method of claim 1 wherein the substrate surface is irradiated with ultraviolet laser radiation.

12. The method of claim 1 wherein the molding surface is pressed into the substrate surface by a mechanical press or by fluid pressure.

13. The method of claim 1 wherein the molding surface is flat to planarize the surface of the substrate.

14. The method of claim 1 wherein the mold is formed of material transparent to ultraviolet radiation, the substrate is silicon, and the substrate is irradiated with ultraviolet laser radiation through the mold.

15. The method of claim 1 wherein the substrate surface comprises a semiconductor material.

16. The method of claim 1 wherein the substrate surface comprises a metal or alloy.

17. The method of claim 1 wherein the substrate surface comprises a polymer.

18. The method of claim 1 wherein the substrate surface comprises a ceramic.

19. The method of claim 1 wherein the substrate surface comprises a plurality of layers of materials to be molded.

20. The method of claim 1 wherein the radiation is infrared radiation.

21. The method of claim 1 wherein the substrate comprises a previously imprinted layer.

22. The method of claim 1 further comprising the step of filling with material the recessed regions of the imprinted patter.

23. The method of claim 1 further comprising the step of repeating the imprinting process at another location on the same substrate.

24. The method of claim 1 wherein the substrate comprises an existing pattern and further comprising the step of aligning the pattern on the mold to the existing pattern on the substrate.

25. The method of claim 1 further comprising the step of planarizing the substrate prior to imprinting the substrate.

## Patentansprüche

1. Verfahren zum Direktdrucken einer Formstruktur auf die Oberfläche (25) eines Substrats (24), umfassend die folgenden Schritte:
Bereitstellen (A) einer Form (20) mit einer Formoberfläche (21) zum Drucken der Struktur;
Anordnen (B) der Form nahe dem Substrat mit der Formoberfläche angrenzend an die zu bedruckende Substratoberfläche;
Bestrahlen (C) der Substratoberfläche mit Strahlung, um die Substratoberfläche aufzuweichen oder zu verflüssigen;
Drücken (D) der Formoberfläche in die aufgeweichte oder verflüssigte Substratoberfläche und
Entfernen (E) der Formoberfläche vom Substrat, um das Substrat mit der gedruckten Struktur auf der Formoberfläche zurückzulassen;
**gekennzeichnet dadurch, dass** der Bestrahlungsschritt die Oberfläche mit Pulsstrahlung bestrahlt, die mit einer Zeitdauer im Bereich von 1 ns bis 10 s pulsiert, so dass nur eine Oberflächenschicht des Substrats erhitzt wird und der Rest des Substrats nicht signifikant erhitzt wird.

2. Verfahren nach Anspruch 1, wobei die Strahlung Laserstrahlung ist.

3. Verfahren nach Anspruch 2, wobei die Laserstrahlung von einer Wellenlänge im Bereich 1 nm bis 100 µm ist.

4. Verfahren nach Anspruch 1, wobei die Strahlung Lampenstrahlung ist.

5. Verfahren nach Anspruch 4, wobei die Lampenstrahlung vorrangig im Bereich 1 nm bis 50 µm liegt.

6. Verfahren nach Anspruch 1, wobei die Bestrahlung wiederholt gepulst wird, während die Form gegen das Substrat gedrückt wird.

7. Verfahren nach Anspruch 1, wobei die Form ein für die Strahlung transparentes Material umfasst.

8. Verfahren nach Anspruch 1, wobei die Form Quarzglas umfasst.

9. Verfahren nach Anspruch 1, wobei die Formoberfläche eine Struktur von hervorragenden und zurückgesetzten Merkmalen mit mindestens einem Merkmal mit einer minimalen Abmessung von weniger als 200 nm aufweist.

10. Verfahren nach Anspruch 1, wobei die Formoberfläche eine Struktur von hervorragenden und zurückgesetzten Merkmalen mit einer Formtiefe von weniger als 250 nm vom äußeren Abschnitt eines herausragenden Merkmals zum inneren Abschnitt eines angrenzenden zurückgesetzten Bereichs aufweist.

11. Verfahren nach Anspruch 1, wobei die Substratoberfläche mit ultravioletter Laserstrahlung bestrahlt wird.

12. Verfahren nach Anspruch 1, wobei die Formoberfläche durch eine mechanische Presse oder mittels Fluiddruck in die Substratoberfläche gedrückt wird.

13. Verfahren nach Anspruch 1, wobei die Formoberfläche flach ist, um die Oberfläche des Substrats zu ebnen.

14. Verfahren nach Anspruch 1, wobei die Form aus einem für ultraviolette Strahlung transparenten Material gebildet ist, das Substrat Silicium ist und das Substrat durch die Form mit ultravioletter Laserstrahlung bestrahlt wird.

15. Verfahren nach Anspruch 1, wobei die Substratoberfläche ein Halbleitermaterial umfasst.

16. Verfahren nach Anspruch 1, wobei die Substratoberfläche ein Metall oder eine Legierung umfasst.

17. Verfahren nach Anspruch 1, wobei die Substratoberfläche ein Polymer umfasst.

18. Verfahren nach Anspruch 1, wobei die Substratoberfläche ein Keramikmaterial umfasst.

19. Verfahren nach Anspruch 1, wobei die Substratoberfläche mehrere Schichten von zu formenden Materialien umfasst.

20. Verfahren nach Anspruch 1, wobei die Strahlung Infrarotstrahlung ist.

21. Verfahren nach Anspruch 1, wobei das Substrat eine zuvor gedruckte Schicht umfasst.

22. Verfahren nach Anspruch 1, ferner umfassend das Füllen der zurückgesetzten Bereiche der gedruckten Struktur mit Material.

23. Verfahren nach Anspruch 1, ferner umfassend das Wiederholen des Druckvorgangs an einer anderen Stelle auf dem gleichen Substrat.

24. Verfahren nach Anspruch 1, wobei das Substrat eine existierende Struktur aufweist, ferner umfassend das Ausrichten der Struktur auf der Form an der existierenden Struktur auf dem Substrat.

25. Verfahren nach Anspruch 1, ferner umfassend das Ebnen des Substrats vor dem Bedrucken des Substrats.

## Revendications

1. Procédé pour imprimer directement un motif de moule sur la surface (25) d'un substrat (24) comprenant les étapes consistant à :
fournir (A) un moule (20) comportant une surface de moulage (21) pour imprimer le motif ;
disposer (B) le moule à proximité du substrat, la surface de moulage étant adjacente à la surface de substrat à imprimer ;
exposer (C) la surface de substrat à un rayonnement pour ramollir ou liquéfier la surface de substrat ;
presser (D) la surface de moulage dans la surface de substrat ramollie ou liquéfiée ; et
ôter (E) la surface de moulage du substrat pour laisser sur le substrat le motif imprimé de la surface de moulage ;
**caractérisé en ce que** l'étape d'exposition à rayonnement expose la surface à un rayonnement pulsé qui est pulsé à une durée d'impulsion comprise entre 1 nanoseconde et 10 secondes de manière que seule une couche de surface du substrat soit chauffée et le reste du substrat ne soit pas chauffé significativement.

2. Procédé selon la revendication 1, dans lequel le rayonnement est un rayonnement laser.

3. Procédé selon la revendication 2, dans lequel le rayonnement laser a une longueur d'onde dans la plage de 1 nanomètre à 100 micromètres.

4. Procédé selon la revendication 1, dans lequel le rayonnement est un rayonnement de lampe.

5. Procédé selon la revendication 4, dans lequel le rayonnement de lampe est principalement dans la plage de 1 nanomètre à 50 micromètres.

6. Procédé selon la revendication 1, dans lequel le rayonnement est pulsé de manière répétée tandis que le moule est pressé contre le substrat.

7. Procédé selon la revendication 1, dans lequel le moule comprend un matériau transparent au rayonnement.

8. Procédé selon la revendication 1, dans lequel le moule comprend du quartz fondu.

9. Procédé selon la revendication 1, dans lequel la surface de moulage comprend un motif de caractéristiques en retrait et en saillie comportant au moins une caractéristique ayant une dimension minimale inférieure à 200 nanométres.

10. Procédé selon la revendication 1, dans lequel la surface de moulage comprend un motif de caractéristiques en retrait et en saillie ayant une profondeur de moule inférieure à 250 nanomètres de la partie externe d'une caractéristique en saillie à la partie interne d'une région en retrait adjacente.

11. Procédé selon la revendication 1, dans lequel la surface de substrat est exposée à un rayonnement laser ultraviolet.

12. Procédé selon la revendication 1, dans lequel la surface de moulage est pressée dans la surface de substrat par une presse mécanique ou par pression fluidique.

13. Procédé selon la revendication 1, dans lequel la surface de moulage est plate pour planariser la surface du substrat.

14. Procédé selon la revendication 1, dans lequel le moule est constitué d'un matériau transparent au rayonnement ultraviolet, le substrat est du silicium, et le substrat est exposé à un rayonnement laser ultraviolet à travers le moule.

15. Procédé selon la revendication 1, dans lequel la surface de substrat comprend un matériau semi-conducteur.

16. Procédé selon la revendication 1, dans lequel la surface de substrat comprend un métal ou un alliage.

17. Procédé selon la revendication 1, dans lequel la surface de substrat comprend un polymère.

18. Procédé selon la revendication 1, dans lequel la surface de substrat comprend une céramique.

19. Procédé selon la revendication 1, dans lequel la surface de substrat comprend une pluralité de couches de matériaux à mouler.

20. Procédé selon la revendication 1, dans lequel le rayonnement est un rayonnement infrarouge.

21. Procédé selon la revendication 1, dans lequel le substrat comprend une couche imprimée au préalable.

22. Procédé selon la revendication 1, comprenant, en outre, l'étape consistant à remplir de matériau les régions en retrait du motif imprimé.

23. Procédé selon la revendication 1, comprenant, en outre, l'étape consistant à répéter l'opération d'impression en un autre emplacement sur le même substrat.

24. Procédé selon la revendication 1, dans lequel le substrat comprend un motif existant et comprenant, en outre, l'étape consistant à aligner le motif sur le moule avec le motif existant sur le substrat.

25. Procédé selon la revendication 1, comprenant, en outre, l'étape consistant à planariser le substrat avant impression du substrat.
